# FASCICULE DE BREVET EUROPEEN

(11) **EP 2 780 698 B1**
(45) Date de publication et mention de la délivrance du brevet: **30.09.2015**
(21) Numéro de dépôt: 12806528.1
(22) Date de dépôt: 15.11.2012
(51) Int. Cl.: G01N 23/225, H01J 37/28

(54) **DISPOSITIF D'ANALYSE D'UN MATÉRIAU IRRADIANT À L'AIDE D'UNE MICROSONDE**
VORRICHTUNG ZUR ANALYSE EINES STRAHLENDEN MATERIALS MITTELS EINER MIKROSONDE
DEVICE FOR ANALYSING A RADIATING MATERIAL USING A MICROPROBE

(30) Priorité: 15.11.2011 FR 1103461
(43) Date de publication de la demande: 24.09.2014
(73) Titulaire: Commissariat à l'Énergie Atomique et aux Énergies Alternatives, 75015 Paris (FR)
(72) Inventeur: LAMONTAGNE, Jérôme, F-04100 Manosque (FR); BLAY, Thierry, F-13490 Jouques (FR); BENARD, Philippe, F-95600 Eaubonne (FR)
(74) Mandataire: Marchand, André
(86) Numéro de dépôt international: PCT/FR2012/000462
(87) Numéro de publication internationale: WO 2013/072580

(56) Documents cités:
- EP-A1- 0 562 874
- JP-A- 2001 153 760
- JP-A- 2005 203 556
- US-A1- 2005 139 781

## Description

### DOMAINE TECHNIQUE

La présente invention est relative à un dispositif permettant l'analyse d'un matériau irradiant à l'aide d'une microsonde.

L'invention s'applique notamment à l'analyse d'un échantillon extrait d'une pastille de combustible nucléaire.

### ETAT DE LA TECHNIQUE

Il est connu d'analyser la composition chimique d'un échantillon, en analysant les rayons X - en particulier le spectre des rayons X - émis par une zone de l'échantillon soumise à un bombardement. Selon que l'échantillon est soumis à un bombardement d'électrons ou à un bombardement d'ions, l'appareil permettant d'effectuer cette analyse est dénommé microsonde électronique ou microsonde ionique.

A cet effet, une microsonde électronique comporte notamment une chambre d'analyse destinée à recevoir l'échantillon, un canon à électrons pour émettre un faisceau d'électrons, une colonne électronique focalisant le faisceau d'électrons vers l'échantillon disposé dans la chambre d'analyse, et des spectromètres agencés pour recevoir les rayons X émis par l'échantillon lors de l'interaction entre les électrons et la matière de l'échantillon.

Afin de pouvoir analyser tout ou partie d'un échantillon, celui-ci est généralement disposé sur une table à mouvements croisés permettant de déplacer la zone d'analyse « ponctuelle » soumise au bombardement d'électrons, selon deux axes orthogonaux d'un plan perpendiculaire à l'axe du faisceau d'électrons, ainsi que selon ce dernier axe. Cette table de translation (selon trois axes orthogonaux) qui supporte l'échantillon à analyser est généralement dénommée « mouvement objet ».

L'appareil peut comporter en outre un sas relié à la chambre d'analyse et dans lequel un vide partiel peut être fait, afin de permettre d'introduire dans la chambre d'analyse un échantillon placé dans le sas, sans « casser » complètement le vide dans la chambre d'analyse.

Pour l'analyse d'échantillons radioactifs avec un tel appareil, on peut envisager de placer l'appareil dans une cellule blindée équipée d'une boîte à gants servant à manipuler ou à télé-manipuler les échantillons, avant leur introduction dans l'appareil d'analyse et après leur extraction de l'appareil. Par télé-manipuler, on entend l'action de manipuler à distance, par l'intermédiaire de moyens connus par l'homme du métier, par exemple des pinces manuelles ou électriques.

Le document JP-A-2001153760 divulgue un dispositif d'analyse d'un matériau, comprenant une enceinte principale 14 équipée d'une enceinte secondaire 42, une microsonde placée dans l'enceinte principale et équipée d'un sas 38 et un support mobile 11 d'échantillon déplaçable de l'enceinte secondaire jusqu'au sas et du sas jusqu'au mouvement objet.

Les dispositifs connus d'analyse d'un matériau irradiant à l'aide d'une microsonde ne permettent pas d'assurer un niveau de sûreté suffisant.

Il faut en effet éviter toute rupture de confinement de l'échantillon, de la boîte à gants jusqu'à la chambre d'analyse, pour ne pas contaminer la cellule blindée par des poussières radioactives issues de l'échantillon.

Il faut en outre pouvoir effectuer et contrôler de façon fiable le transfert de l'échantillon depuis la boîte à gants jusqu'au mouvement objet, ainsi que le transfert en sens inverse, y compris en cas de panne de l'appareil d'analyse.

Un autre problème à résoudre est d'éviter de transmettre à l'appareil d'analyse des vibrations mécaniques résultant de la ventilation forcée permettant de maintenir la boîte à gants en dépression par rapport à la cellule blindée.

### EXPOSÉ DE L'INVENTION

Un objectif de l'invention est de proposer un dispositif d'analyse d'un matériau à l'aide d'une microsonde qui soit amélioré et/ou qui remédie, en partie au moins, aux lacunes ou inconvénients des dispositifs connus d'analyse par microsonde.

Selon un aspect de l'invention, il est proposé un dispositif d'analyse qui comporte une enceinte principale telle qu'une cellule blindée, qui est équipée d'une enceinte secondaire telle qu'une boîte à gants, ainsi qu'une microsonde placée dans l'enceinte principale et équipée d'un sas ; le dispositif comporte en outre un support mobile d'échantillon déplaçable de l'enceinte secondaire jusqu'au sas et du sas jusqu'au mouvement objet ; de plus, le sas et le mouvement objet comportent chacun un organe de guidage du support mobile d'échantillon pour guider ce support lors de son déplacement, ainsi qu'un moyen de détection de présence du support mobile d'échantillon pour contrôler la position de ce support mobile.

Le mouvement objet peut comporter en outre une butée (mécanique) servant à maintenir en position d'analyse le support mobile d'échantillon.

Le dispositif d'analyse comporte de préférence en outre une barre de commande - telle qu'une tige - coulissante servant à déplacer le support mobile d'échantillon depuis le sas jusqu'au mouvement objet, et inversement.

Dans ce cas, le support mobile d'échantillon et la barre de commande coulissante peuvent respectivement comporter deux organes d'accouplement mécanique complémentaires prévus pour s'engager mutuellement afin d'assurer une liaison mécanique entre la barre de commande et le support mobile d'échantillon.

Le dispositif d'analyse comporte alors de préférence des moyens de verrouillage qui autorisent la désolidarisation mutuelle des organes d'accouplement dans la position d'analyse du support mobile d'échantillon sur le mouvement objet, ainsi que dans une position de transfert du support mobile d'échantillon à l'intérieur du sas, et qui interdisent cette désolidarisation pour toutes les positions du support mobile d'échantillon qui sont intermédiaires entre la position d'analyse et la position de transfert.

Selon un mode préféré de réalisation, le dispositif d'analyse comporte en outre des moyens d'alignement qui servent à aligner l'organe de guidage du sas et l'organe de guidage du mouvement objet, en cas de défaillance de l'alimentation des moteurs d'entraînement de la table à mouvements croisés, pour permettre dans cette hypothèse le retour du support mobile d'échantillon, depuis le mouvement objet jusqu'au sas.

Ces moyens « manuels » d'alignement peuvent comporter, pour chaque axe de la table à mouvements croisés, un organe d'entraînement - tel qu'un volant - en prise avec une vis sans fin servant à entraîner la table en mouvement selon cet axe, cet organe d'entraînement étant actionnable par l'intermédiaire d'un organe de manipulation traversant une paroi de l'enceinte principale.

Ces moyens d'alignement comportent de préférence en outre, pour chaque axe de la table à mouvements croisés, un capteur de position sensible à la position de la table le long de cet axe, et un dispositif d'affichage relié à ce capteur pour afficher, de façon visible à l'extérieur de l'enceinte principale, la position de la table le long de cet axe, ce qui permet à un opérateur agissant sur l'organe de manipulation de contrôler le déplacement « manuel » de la table selon chacun de ces axes, jusqu'à obtenir l'alignement mutuel des organes de guidage respectivement intégrés au mouvement objet et au sas.

Chaque organe de guidage peut comporter un tronçon de rail sur - ou contre - lequel le support mobile d'échantillon peut glisser, coulisser, ou rouler.

A cet effet, le support mobile d'échantillon peut être équipé de patins et/ou de roulettes facilitant son déplacement sur l'organe de guidage, ou le long de celui ci.

Chaque moyen de détection de présence du support mobile d'échantillon peut comporter un capteur électromécanique ou électromagnétique.

Selon un mode de réalisation, une paroi du sas est transparente de façon à permettre un contrôle visuel de la présence du support mobile d'échantillon dans le sas.

Pour le contrôle de la position de l'échantillon - et de celle du support mobile d'échantillon, un repère visuel peut en outre être prévu sur le support mobile d'échantillon pour faciliter un contrôle visuel de la présence du support mobile dans la chambre d'analyse, par l'intermédiaire d'un microscope optique intégré à l'appareil d'analyse.

Selon un mode de réalisation, le dispositif d'analyse comporte en outre une structure creuse reliant le sas à l'enceinte secondaire, à l'intérieur de laquelle peut se déplacer le support mobile d'échantillon, de façon à permettre le transfert de ce support mobile de l'enceinte secondaire jusqu'au sas, et inversement.

Cette structure creuse comporte une enveloppe étanche aux poussières pour éviter la contamination de l'enceinte principale par des poussières radioactives issues de l'échantillon porté par le support mobile.

En outre, cette structure creuse - et de préférence ladite enveloppe étanche - présente une raideur mécanique suffisamment faible pour limiter fortement (ou supprimer) la transmission au sas - et à l'appareil d'analyse - des vibrations de l'enceinte secondaire.

Selon un mode de réalisation, cette structure creuse est essentiellement constituée par une enveloppe tubulaire annelée réalisée dans un matériau plastique, en particulier une enveloppe qui présente une forme de soufflet.

D'autres aspects, caractéristiques, et avantages de l'invention apparaissent dans la description suivante qui se réfère aux figures annexées et illustre, sans aucun caractère limitatif, des modes préférés de réalisation de l'invention.

### BREVE DESCRIPTION DES FIGURES

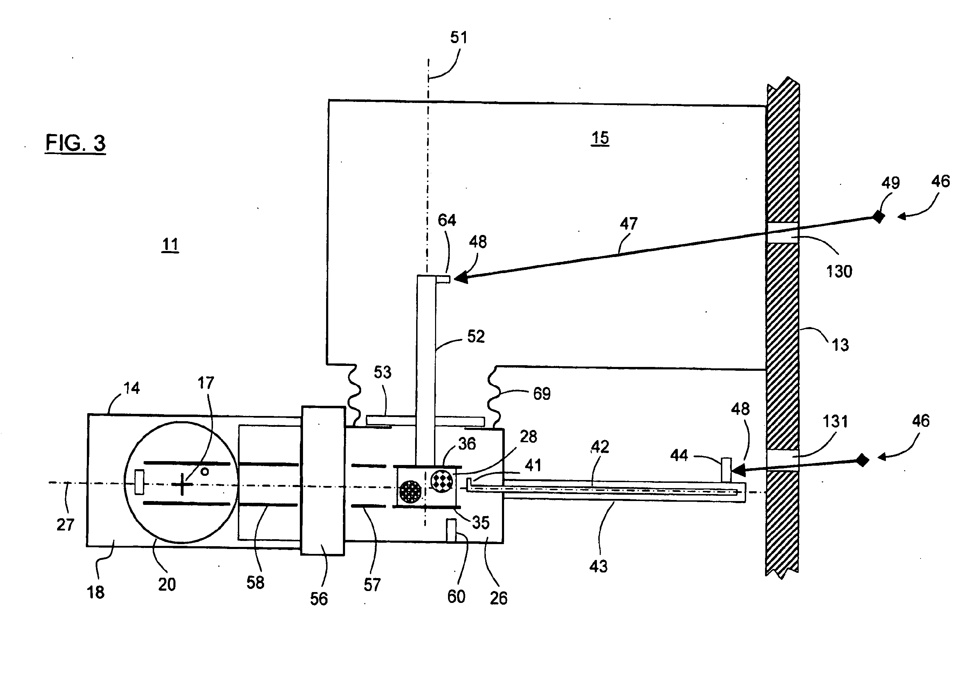

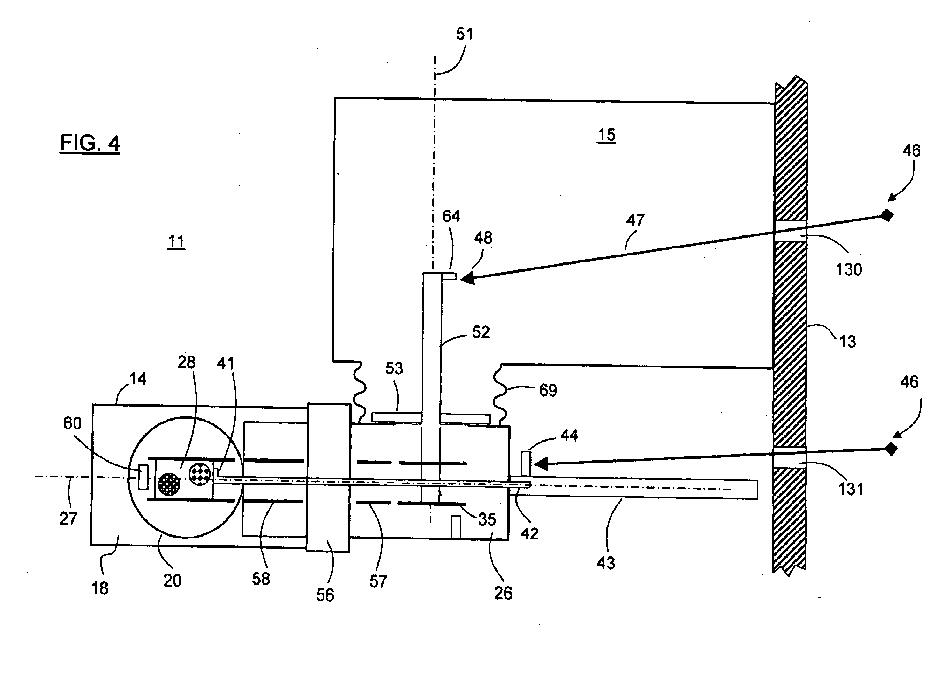

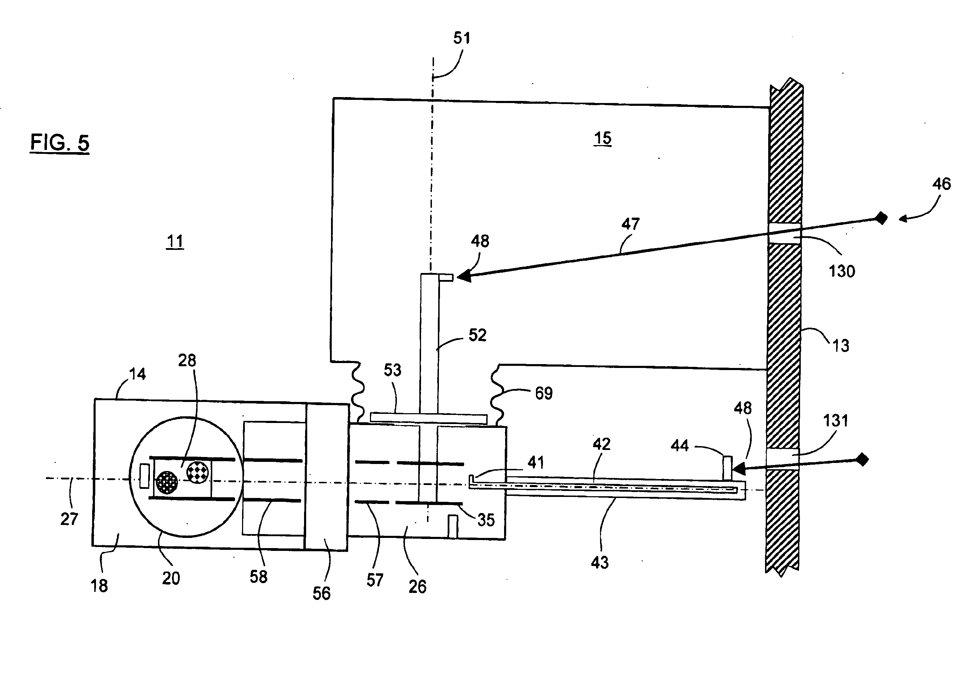

La figure 1 est une vue de coté schématique d'un dispositif d'analyse d'échantillons de matériaux irradiants.
Les figures 2 à 5 sont des vues en plan schématiques du système de transfert d'un support mobile d'échantillon, depuis une enceinte secondaire (ici une boîte à gants) jusqu'au mouvement objet de la microsonde, et inversement, dans plusieurs configurations distinctes :
   - la configuration illustrée figure 2 correspond à une étape de chargement d'un échantillon à analyser, sur un support mobile d'échantillon, dans la boîte à gants ; cette configuration peut également correspondre à une étape de déchargement d'un échantillon déjà analysé ;
   - la configuration illustrée figure 3 correspond à une étape de fermeture du sas contenant le support mobile d'échantillon, pour le tirage au vide du sas, avant le transfert du support d'échantillon dans la chambre d'analyse; cette configuration peut également correspondre à une étape de remise en pression du sas contenant un support mobile portant un échantillon analysé ;
   - la configuration illustrée figure 4 correspond à une étape de transfert du support mobile d'échantillon dans la chambre d'analyse, par une tige de commande coulissante, avant le retrait de cette tige et l'isolement de la chambre d'analyse; cette configuration peut également correspondre à une étape de récupération, à l'aide de la tige de commande, d'un support mobile portant un échantillon analysé ;
   - la configuration illustrée figure 5 correspond à une étape d'analyse de l'échantillon porté par le support mobile d'échantillon.

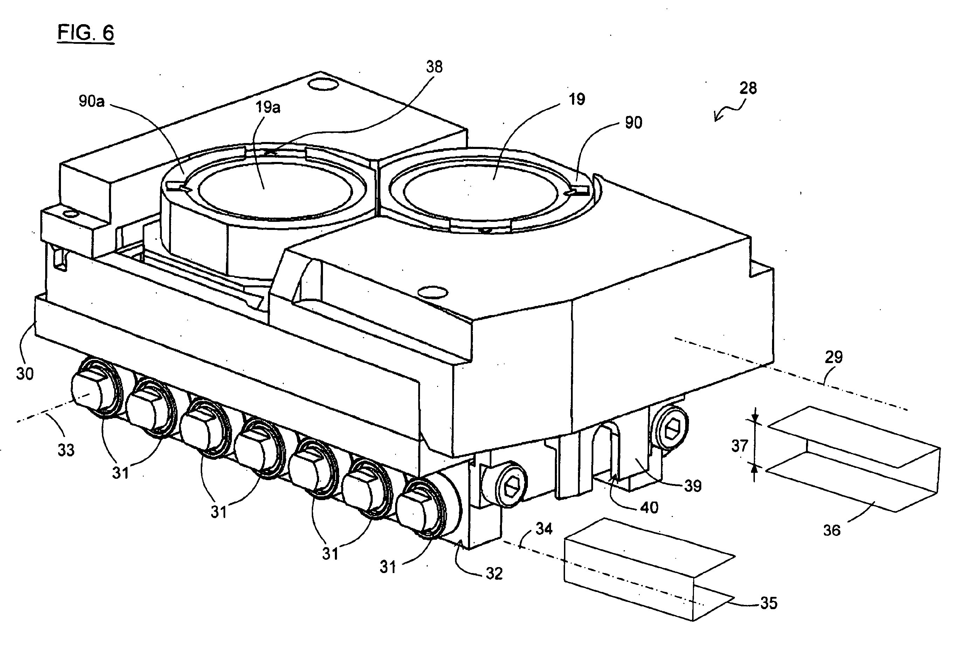

La figure 6 est une vue en perspective schématique d'un support mobile d'échantillon.

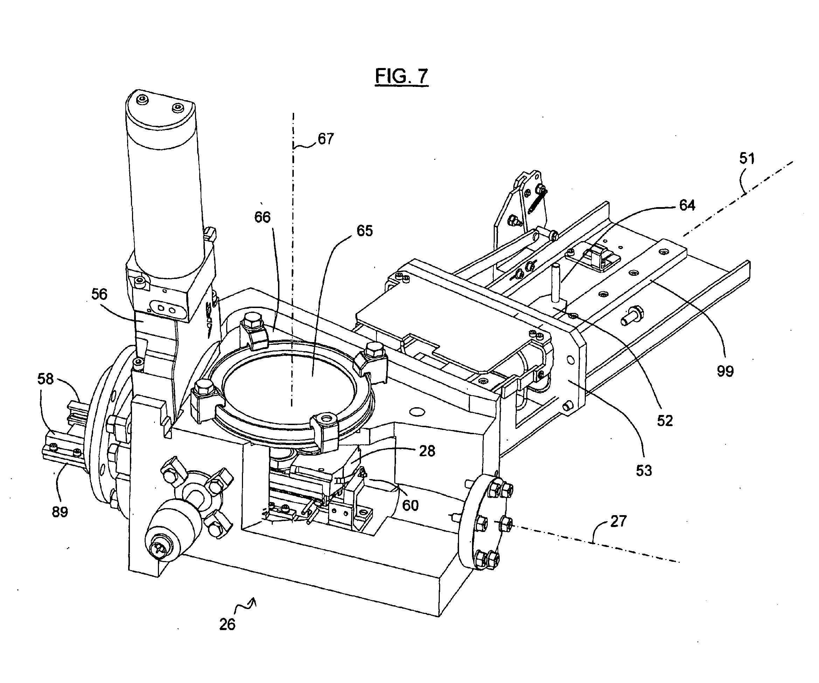

La figure 7 est une vue en perspective du sas avec arrachement partiel.

### DESCRIPTION DETAILLEE DE L'INVENTION

Sauf indication explicite ou implicite contraire, des éléments ou organes - structurellement ou fonctionnellement - identiques ou similaires sont désignés par des repères identiques sur les différentes figures.

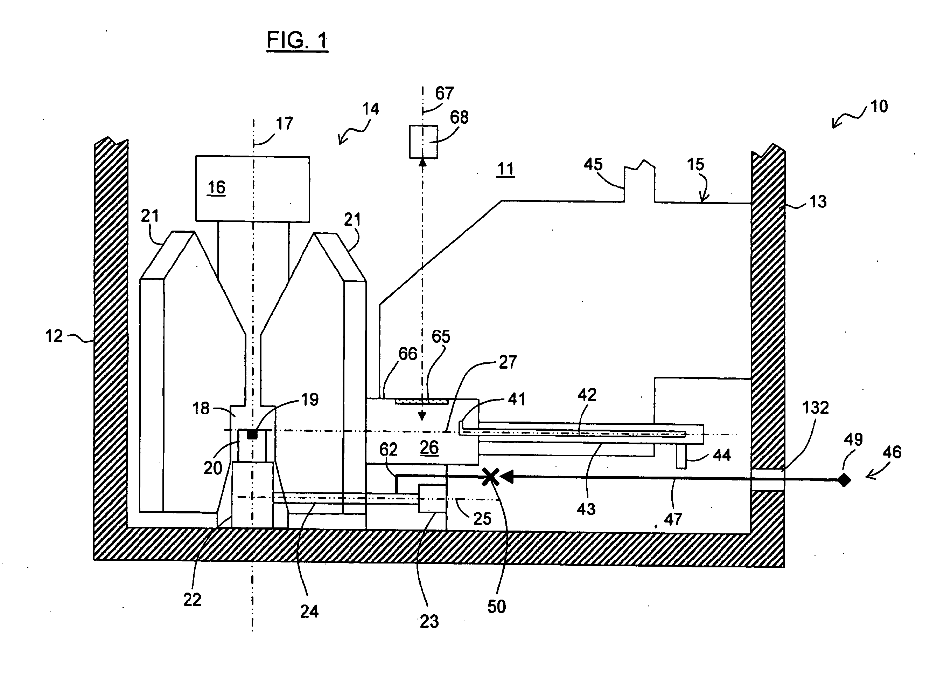

Par référence à la figure 1 notamment, le dispositif 10 d'analyse comporte une enceinte principale - ou cellule - 11 délimitée par des parois 12, 13 blindées.

La cellule 11 contient une microsonde 14 et une boîte à gants 15.

La boîte à gants - ou enceinte secondaire - est reliée par deux conduits - tels que le conduit 45 - à un extracteur et à un ventilateur de soufflage (non représentés), de sorte que le volume délimité par la boîte à gants est maintenu en dépression par rapport à la cellule, pour éviter la contamination de la cellule par des gaz ou poussières radioactifs présents dans la boîte à gants.

La microsonde 14 comporte un canon 16 produisant un faisceau d'électrons dirigé selon un axe 17 vertical, dans une colonne électronique, vers une chambre 18 d'analyse recevant un échantillon 19 à analyser.

A cet effet, l'échantillon 19 est disposé sur un support 20, dans la chambre 18, dans une position telle qu'une portion de l'échantillon soit disposée sur l'axe 17.

La microsonde 14 comporte plusieurs spectromètres 21 agencés autour de la chambre 18 pour recevoir les rayons X émis par l'échantillon soumis au faisceau d'électrons.

Pour pouvoir analyser une zone étendue de l'échantillon, l'échantillon est déplaçable dans la chambre 18 selon l'axe 17 et selon deux axes orthogonaux d'un plan perpendiculaire à l'axe 17.

A cet effet, le support 20 portant l'échantillon est monté sur une table 22 mobile selon ces trois axes orthogonaux deux à deux.

Le déplacement de la table 22, et par conséquent celui du support 20 et de l'échantillon 19, selon chacun de ces trois axes, est obtenu en actionnant un moteur électrique rotatif 23 qui entraine une vis sans fin 24 s'étendant le long d'un axe 25 horizontal, en rotation selon cet axe 25.

De façon connue, un écrou (non représenté) lié à la table et en prise avec la vis 24, provoque le déplacement de la table sous l'effet de la rotation de la vis.

Pour ne pas nuire à la clarté de la figure 1, un seul des trois systèmes 23, 24 d'entraînement du mouvement objet 22, est représenté sur cette figure.

La microsonde 14 est équipée d'un sas 26 permettant l'introduction d'un échantillon dans la chambre d'analyse, puis son extraction de la chambre après analyse, selon un axe 27 horizontal.

Pour ses déplacements dans le dispositif d'analyse 10, l'échantillon 19 est disposé sur un support mobile - ou véhicule - 28 tel que celui illustré figure 6.

Par référence à la figure 6 notamment, le véhicule 28 présente une forme allongée selon un axe longitudinal 29.

Le véhicule 28 comporte un châssis 30 dont la partie inférieure est équipée, sur chacune de ses deux faces latérales longitudinales 32 - dont une seule est visible figure 6 -, de sept roulettes 31 montées libres en rotation selon des axes transversaux tels que celui repéré 33.

Ces roulettes sont alignées selon un axe 34 parallèle à l'axe 29, de sorte qu'elles peuvent s'insérer dans un tronçon de rail de guidage tel que ceux repérés 35 et 36 figure 6.

Chacun de ces rails présente une section en forme de « C », comportant trois ailes longitudinales sensiblement planes, orthogonales deux à deux.

La hauteur 37 séparant les deux ailes horizontales parallèles du rail 35, 36 est adaptée au diamètre des roues 31 du véhicule 28, de sorte que le véhicule 28 peut rouler sur les ailes inférieures horizontales respectives des rails 35, 36.

Le véhicule 28 reçoit dans sa partie supérieure deux coupelles 90, 90a porte échantillon, à l'intérieur desquelles sont respectivement déposés deux échantillons 19, 19a en forme de pastille ou disque: un échantillon 19 à analyser et un échantillon 19a de nature et composition déterminées, servant de référence pour l'analyse de l'échantillon 19 par analyse spectrale des rayons X émis par cet échantillon.

La face supérieure de l'une au moins des coupelles 90, 90a porte un repère visuel 38 susceptible d'être vu par un opérateur, par l'intermédiaire d'un microscope optique (non représenté) équipant la microsonde, lorsque le véhicule 28 est correctement positionné en position d'analysé, dans la chambre d'analyse, sur le mouvement objet 20, 22.

Le véhicule 28 comporte, à une de ses deux extrémités longitudinales, une plaque 39 perpendiculaire à l'axe 29, solidaire du châssis, et pourvue d'une encoche 40 découpée dans la plaque 39 pour former un premier organe d'accouplement.

La forme et les dimensions de l'encoche 40 sont adaptées à la forme et aux dimensions d'un second organe d'accouplement, tel qu'un ergot 41 prévu à l'extrémité d'une tige de commande 42 (41 et 42 étant représentés sur les figures 1 à 5) équipant la microsonde, de sorte que ces deux organes d'accouplement mécanique complémentaires peuvent assurer une liaison mécanique « temporaire » entre la tige de commande 42 et le véhicule 28.

Par référence aux figures 1 à 5, la tige de commande 42 s'étend selon l'axe 27 et est montée mobile en translation et en rotation selon cet axe, à l'intérieur d'un fourreau 43 tubulaire étanche s'étendant également selon cet axe.

Le fourreau 43 est fixé au sas 26 par une première de ses deux extrémités longitudinales et est fermé à sa seconde extrémité longitudinale.

Un organe 44 de transmission de mouvement est monté coulissant selon l'axe 27, autour - et le long - du fourreau 43.

Cet organe de transmission 44 est relié par une liaison magnétique à la barre de commande 42, de sorte que les mouvements de translation et de rotation - selon l'axe 27 - de l'organe 44 sont transmis à la barre de commande 42.

Comme décrit ci après en relation avec les figures 3 à 5, la barre - ou tige - de commande 42 coulissante sert à déplacer le véhicule 28 support d'échantillon depuis le sas jusqu'au mouvement objet, et inversement.

Le dispositif d'analyse comporte également plusieurs organes 46 de manipulation comportant chacun une barre 47 pourvue, à une première de ses extrémités, d'un outil 48 de préhension (ou manipulation) - tel qu'une pince -, et pourvue à sa seconde extrémité d'un outil 49 de commande, tel qu'une poignée, qui est relié à l'outil 48 de préhension.

Chaque organe 46 - en particulier chaque barre 47 - s'étend au travers d'un orifice 130 à 132 percé dans la paroi 13 de la cellule 11, de façon à permettre à un opérateur situé à l'extérieur de la cellule 11, d'actionner l'outil 48 de préhension de l'organe 46 considéré, qui est situé à l'intérieur de la cellule 11, en agissant sur l'outil 49 de commande.

Sur les figures 1 à 5, chaque outil de préhension 48 est schématiquement représenté par une pointe de flèche tandis que chaque outil de commande 49 est schématiquement représenté par un losange noirci.

Ainsi, l'organe 46 de manipulation représenté figure 1 permet à un opérateur agissant sur cet organe de mettre en prise l'outil de préhension de cet organe avec un volant 50 d'entraînement qui est lui-même en prise avec une des trois vis 24 sans fin servant à entraîner la table 22 en mouvement, par l'intermédiaire d'une liaison de transmission mécanique 62 schématiquement représentée sur cette figure par un trait coudé.

Ceci permet à l'opérateur d'aligner, par une action manuelle sur l'outil de commande 49, le support 20 d'échantillon qui est présent dans la chambre d'analyse avec les moyens de transfert de l'échantillon vers le sas, notamment en cas de défaillance de l'alimentation des moteurs d'entraînement de la table à mouvements croisés.

Ceci permet plus particulièrement d'aligner les rails de guidage du sas et les rails de guidage du mouvement objet qui sont décrits ci après.

Pour chaque axe de la table 22, le dispositif d'analyse comporte un capteur de position (non représenté) sensible à la position de la table le long de cet axe, et un dispositif d'affichage (non représenté) relié à ce capteur pour afficher à l'extérieur de la cellule 11, la position de la table le long de cet axe.

Ce dispositif de contrôle de la position de la table 22 peut par exemple être essentiellement constitué, pour chaque axe de déplacement de la table, d'un compte tour mécanique en prise avec le volant 50, la transmission 62, et/ou la vis 24.

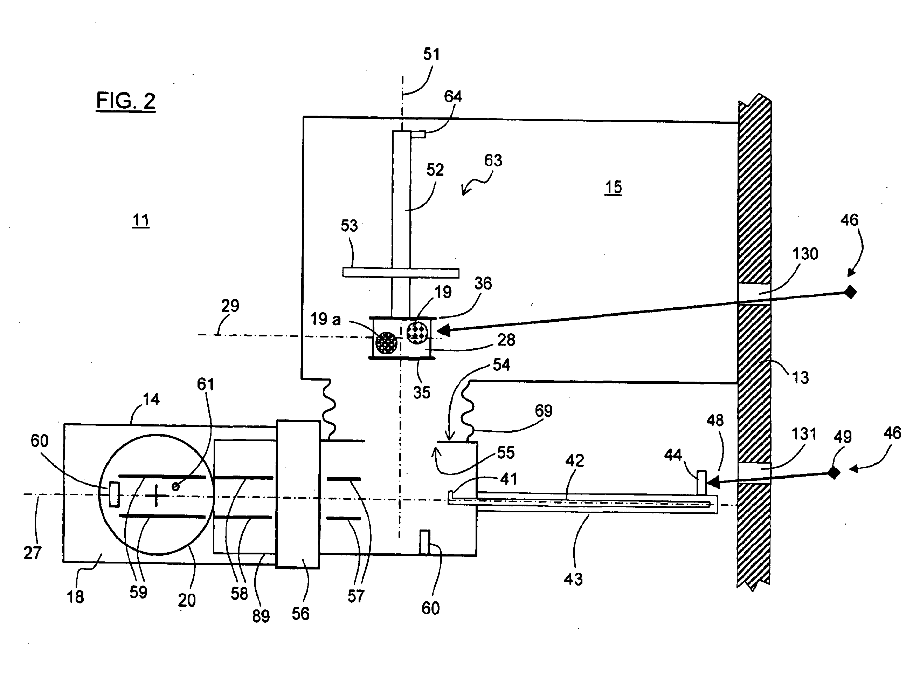

Par référence aux figures 2 à 5 notamment, le dispositif d'analyse comporte un système de transport du véhicule 28 support d'échantillon, de la boîte à gants 15 jusqu'au sas 26, du sas jusqu'au support 20 porté par le mouvement objet, et inversement.

Pour le transfert du véhicule 28 de la boîte à gants 15 jusqu'au sas 26, le dispositif comporte une structure 63 de transfert montée mobile en translation par rapport au sas, selon un axe 51 sensiblement horizontal et incliné par rapport à l'axe 27 - par exemple sensiblement perpendiculaire à l'axe 27 -.

A cet effet, la structure 63 de transfert peut être montée coulissante sur un rail 99 allongé selon l'axe 51 et solidaire de la structure délimitant le sas 26, comme illustré figure 7.

Cette structure 63 de transfert comporte une barre 52 allongée selon l'axe 51 et deux tronçons de rail 35, 36 parallèles à l'axe 27 qui sont solidaires de la barre 52, à une première extrémité de la barre 52.

La barre 52 comporte, à sa seconde extrémité, une saillie 64 par l'intermédiaire de laquelle la barre peut être déplacée le long de l'axe 51, par un outil 48 de préhension d'un organe 46 de manipulation actionné par un opérateur.

Les tronçons de rail 35, 36 peuvent être identiques à ceux représentés figure 6, se faisant face et pouvant chacun recevoir une des deux rangées de roulettes du véhicule 28 qu'ils supportent.

La structure 63 de transfert comporte une plaque 53 solidaire de la barre 52 et servant à fermer une ouverture 55 prévue dans une paroi latérale 54 du sas, pour permettre le tirage au vide du sas.

La microsonde comporte une vanne 56 à guillotine servant à isoler la chambre d'analyse 18 du sas 26, et à permettre de faire le vide dans la chambre 18.

Le sas 26, une structure fixe 89 s'étendant dans la chambre 18 dans le prolongement du sas (selon l'axe 27), ainsi que le support 20 porté par le mouvement objet, comportent chacun une paire de rails 57 à 59 de guidage du véhicule 28 pour guider ce véhicule lors de son déplacement le long de l'axe 27, depuis le sas jusqu'au support 20, et inversement.

Les rails 57 à 59 présentent un écartement identique. Les rails 57 et 58 sont alignés selon deux axes parallèles à l'axe 27. Les rails 59 solidaires du support 20 sont également alignés avec les rails 57, 58, dans une position du mouvement objet, pour permettre le transfert du véhicule 28 entre les rails 58 et 59.

Lorsque, comme indiqué ci avant, les moteurs d'entraînement du mouvement objet ne peuvent être actionnés pour obtenir cette position d'alignement mutuel des rails 58, 59 autorisant le retour du véhicule dans le sas, l'alignement de ces rails peut être obtenu par action sur les trois volants 50 d'entraînement respectif des trois vis sans fin 24.

En outre, le sas 26 et le support 20 comportent chacun un capteur 60 de détection de présence du véhicule 28.

Le support 20 comporte également une butée mécanique 61 permettant de maintenir le véhicule 28 en position d'analyse sur le support 20.

Par référence aux figures 2 à 5 notamment, le dispositif d'analyse peut être utilisé de la façon suivante :

Un échantillon 19 d'un matériau à analyser est introduit dans la boîte à gants 15 (par des moyens non représentés).

Un opérateur agissant sur la poignée de commande 49 d'un organe 46 de manipulation, peut disposer l'échantillon 19 dans une coupelle 90 d'un véhicule 28 dont les roues sont engagées dans les rails 35, 36 de la structure 63 de transfert, et dont l'axe longitudinal 29 est parallèle à l'axe 27, comme dans la configuration illustrée figure 2.

L'opérateur peut ensuite engager la saillie 64 et l'outil de préhension 48 de l'organe 46, et appliquer un effort sur cette saillie de façon à faire coulisser la structure 63 selon l'axe 51, en direction du sas 26, jusqu'à ce que la plaque 53 vienne en appui contre la paroi 54 du sas, et que les rails 35, 36 viennent (simultanément) dans l'alignement des rails 57 à 59, comme dans la configuration illustrée figure 3.

Dans cette configuration, la vanne 56 étant fermée et l'ouverture 55 de passage prévue dans la paroi 54 étant obturée par la plaque 53, le sas 26 est mis en dépression jusqu'à atteindre un vide déterminé.

Lorsque le vide souhaité est atteint, l'organe 41 d'accouplement prévu à l'extrémité de la barre 42 de commande est engagé dans l'échancrure 40 prévue dans la plaque 39 du véhicule 28, par exemple par des mouvements de translation et de rotation de la barre 42 qui résultent de l'action d'un opérateur sur l'organe 46 de manipulation illustré figure 1, par l'intermédiaire de l'outil 48 de préhension de cet organe qui agit sur l'organe 44 de transmission de mouvement.

La vanne 56 étant ouverte, l'opérateur peut alors faire rouler le véhicule 28, successivement sur les rails 35, 36, puis 57, puis 58, puis 59, jusqu'à engager le véhicule 28 avec la butée 61, sur le support 20 porté par le mouvement objet 22, ce qui correspond à la configuration illustrée figure 4, en agissant sur le même organe 46 de manipulation, par l'intermédiaire de l'organe 44 et de la barre 42.

L'organe 41 d'accouplement équipant la barre 42 de commande peut alors être désengagé de l'organe 39, 40 d'accouplement du véhicule 28, par exemple par des mouvements de translation et de rotation de la barre 42 qui résultent de l'action de l'opérateur sur l'organe 44, et la barre 42 peut être de la même façon entrainée en coulissement selon l'axe 27 pour revenir se loger dans le fourreau 43, comme illustré figure 5.

Des moyens de verrouillage qui autorisent la désolidarisadon mutuelle du véhicule 28 et de la barre 42 dans la position d'analyse du véhicule 28 illustrée figure 4, ainsi que dans la position de transfert du véhicule 28 à l'intérieur du sas qui est illustrée figure 3, et qui interdisent cette désolidarisation pour toutes les positions du véhicule 28 intermédiaires entre ces deux positions, peuvent comporter un ergot solidaire de la barre 42 et une piste (prévue dans le fourreau) dans laquelle est engagé cet ergot, de sorte que la barre 42 ne puisse pivoter selon l'axe 27 que dans ces deux positions.

Par référence aux figures 1 et 7, outre le contrôle de la position du véhicule 28 porte échantillon par les capteurs 60, un contrôle visuel peut être réalisé grâce à la présence d'un hublot 65 transparent prévu dans la paroi supérieure 66 du sas, au dessus de la région du sas recevant le véhicule en transfert entre la boîte à gants et la chambre d'analyse.

Ce contrôle visuel peut être opéré par l'intermédiaire d'une caméra 68 placée dans la cellule 11 et observant en direction 67 du hublot 65.

Comme illustré figures 2 à 5, le dispositif d'analyse comporte un soufflet 69 reliant le sas à la boîte à gants, à l'intérieur duquel peut se déplacer le véhicule 28, de façon à permettre le transfert de ce véhicule de la boîte à gants jusqu'au sas, et inversement.

Un tel soufflet étanche aux poussières permet d'éviter la contamination de la cellule 11 par l'échantillon porté par le véhicule 28, et de limiter ou supprimer la transmission des vibrations de la boîte à gants aux parois du sas et à la microsonde.

## Revendications

1. . Dispositif (10) d'analyse d'un matériau à l'aide d'une microsonde (14), comportant :
- une enceinte principale (11) contenant une enceinte secondaire (15) ;
- une microsonde (14) placée dans l'enceinte principale et équipée d'un mouvement objet (20, 22);
- un sas (26) placé dans l'enceinte principale et relié à la microsonde et à l'enceinte secondaire ;
- un support (28) mobile d'échantillon déplaçable de l'enceinte secondaire jusqu'au sas et du sas jusqu'au mouvement objet ;
et dans lequel le sas et le mouvement objet comportent chacun un organe (57, 59) de guidage du support mobile d'échantillon pour guider ce support lors de son déplacement, ainsi qu'un capteur (60) de détection de présence du support mobile d'échantillon.

2. Dispositif selon la revendication 1 dans lequel le movement objet comporte une butée (61) servant à maintenir en position d'analyse le support mobile d'échantillon.

3. Dispositif selon la revendication 1 ou 2 qui comporte une barre (42) de commande coulissante servant à déplacer le support mobile d'échantillon depuis le sas jusqu'au mouvement objet, et inversement.

4. Dispositif selon la revendication 3 dans lequel le support mobile d'échantillon et la barre de commande coulissante comportent respectivement deux organes (39 à 41) d'accouplement complémentaires prévus pour s'engager mutuellement afin d'assurer une liaison mécanique entre la barre de commande et le support mobile d'échantillon.

5. Dispositif selon la revendication 4 qui comporte des moyens de verrouillage qui autorisent la désolidarisation mutuelle des organes d'accouplement dans une position du support mobile d'échantillon sur le mouvement objet, dite position d'analyse, ainsi que dans une position du support mobile d'échantillon à l'intérieur du sas, dite position de transfert, et qui interdisent cette désolidarisation pour toutes les positions du support mobile d'échantillon qui sont intermédiaires entre la position d'analyse et la position de transfert.

6. Dispositif selon l'une quelconque des revendications 1 à 5 qui comporte des moyens d'alignement servant à aligner l'organe (57) de guidage du sas et l'organe (59) de guidage du mouvement objet, en cas de défaillance de l'alimentation des moteurs (23) d'entraînement du mouvement objet.

7. Dispositif selon la revendication 6 dans lequel les moyens d'alignement comportent, pour chaque axe de déplacement du mouvement objet, un organe (50) d'entraînement en prise avec une vis sans fin (24) servant à entraîner le mouvement objet selon cet axe, cet organe d'entraînement étant actionnable par l'intermédiaire d'un organe (46) de manipulation traversant une paroi (13) de l'enceinte principale.

8. Dispositif selon la revendication 6 ou 7 dans lequel les moyens d'alignement comportent, pour chaque axe du mouvement objet, un capteur de position sensible à la position du mouvement objet le long de cet axe, et un dispositif d'affichage relié à ce capteur pour afficher, de façon visible à l'extérieur de l'enceinte principale, la position du mouvement objet le long de cet axe.

9. Dispositif selon l'une quelconque des revendications 1 à 8 dans lequel au moins un des organes de guidage comporte un tronçon de rail (35, 36, 57 à 59) sur - ou contre - lequel le support mobile d'échantillon peut glisser, coulisser, ou rouler.

10. Dispositif selon l'une quelconque des revendications 1 à 9 dans lequel le support mobile d'échantillon est équipé de patins et/ou de roulettes (31) facilitant son déplacement sur l'organe de guidage - ou le long de celui ci.

11. Dispositif selon l'une quelconque des revendications 1 à 10 dans lequel une paroi (65) du sas est transparente.

12. Dispositif selon l'une quelconque des revendications 1 à 11 dans lequel le support mobile d'échantillon comporte un repère visuel (38).

13. Dispositif selon l'une quelconque des revendications 1 à 12 qui comporte une structure (69) creuse reliant le sas à l'enceinte secondaire, à l'intérieur de laquelle peut se déplacer le support mobile d'échantillon, de façon à permettre le transfert de ce support mobile de l'enceinte secondaire jusqu'au sas, et inversement.

14. Dispositif selon la revendication 13 dans lequel la structure creuse (69) comporte une enveloppe étanche aux poussières qui présente une raideur mécanique faible pour limiter la transmission au sas des vibrations de l'enceinte secondaire, cette structure creuse pouvant être essentiellement constituée par une enveloppe tubulaire annelée réalisée dans un matériau plastique, en particulier une enveloppe qui présente une forme de soufflet.

15. Dispositif selon l'une quelconque des revendications 1 à 14 dans lequel l'enceinte principale est délimitée par des parois (12, 13) blindées.

16. Dispositif selon l'une quelconque des revendications 1 à 15 dans lequel l'enceinte secondaire est une boîte à gants maintenue en dépression par rapport à l'enceinte principale.

## Patentansprüche

1. Vorrichtung (10) zur Analyse eines Werkstoffes mit Hilfe einer Mikrosonde (14), umfassend:
- eine Hauptkammer (11), die eine Sekundärkammer (15) enthält,
- eine Mikrosonde (14), die in der Hauptkammer angeordnet und mit einem Objektantrieb (20, 22) versehen ist,
- eine in der Hauptkammer angeordnete und mit der Mikrosonde und der Sekundärkammer verbundene Schleuse (26),
- einen beweglichen Probenträger (28), der von der Sekundärkammer in die Schleuse gebracht werden kann und von der Schleuse zum Objektantrieb,
wobei die Schleuse und der Objektantrieb jeweils ein Organ (57, 59) zur Führung des beweglichen Probenträgers aufweisen, um diesen Träger während seiner Bewegungen zu führen, sowie einen Sensor (60) zur Erfassung der Anwesenheit des beweglichen Probenträgers.

2. Vorrichtung nach Patentanspruch 1, in der der Objektantrieb einen Anschlag (61) aufweist, der dazu dient, den beweglichen Probenträger in der Analysenstellung zu halten.

3. Vorrichtung nach Patentanspruch 1 oder 2, die einen verschiebbaren Betätigungsstab (42) aufweist, der dazu dient, den beweglichen Probenträger von der Schleuse zum Objektantrieb und umgekehrt zu bringen.

4. Vorrichtung nach Patentanspruch 3, in der der bewegliche Probenträger und der verschiebbare Betätigungsstab jeweils zwei komplementäre Kopplungsorgane (39 bis 41) aufweisen, die dazu vorgesehen sind, miteinander in Eingriff zu gelangen, um eine mechanische Verbindung zwischen dem Betätigungsstab und dem beweglichen Probenträger sicherzustellen.

5. Vorrichtung nach Patentanspruch 4, die Verriegelungsmittel aufweist, die in einer Stellung des beweglichen Probenträgers auf dem Objektantrieb, Analysenstellung genannt, die Trennung der Kopplungsorgane voneinander ermöglichen, sowie in einer Stellung des beweglichen Probenträgers im Inneren der Schleuse, Übergabestellung genannt, und die diese Trennung in allen anderen Stellungen des beweglichen Probenträgers verhindern, die zwischen der Analysenstellung und der Übergabestellung liegen.

6. Vorrichtung nach irgendeinem der Patentansprüche 1 bis 5, die Ausrichtungsmittel aufweist, dazu dienend. das Führungsorgan (57) der Schleuse und das Führungsorgan (59) des Objektantriebs im Fall eines Ausfalls der Energieversorgung der Antriebsmotoren (23) des Objektantriebes auszurichten.

7. Vorrichtung nach Patentanspruch 6, in der die Ausrichtungsmittel für jede Bewegungsachse des Objektantriebs ein Antriebsorgan (50) umfassen, das mit einer Endlosschraube (24) in Eingriff steht, die dazu dient, den Objektantrieb längs dieser Achse anzutreiben, wobei dieses Antriebsorgan über ein Manipulationsorgan (46) betätigbar ist, das eine Wand (13) der Hauptkammer durchquert.

8. Vorrichtung nach Patentanspruch 6 oder 7, in der die Ausrichtungsmittel für jede Achse des Objektantriebs einen Stellungssensor umfassen, der die Stellung des Objektantriebs auf dieser Achse erfasst, und eine mit diesem Sensor verbundene Anzeigevorrichtung zur Anzeige der Stellung des Objektantriebs auf dieser Achse in einer außerhalb der Hauptkammer sichtbaren Weise.

9. Vorrichtung nach irgendeinem der Patentansprüche 1 bis 8, in der mindestens eins der Führungsorgane ein Schienenstück (35, 36, 57 bis 59) umfasst, auf dem - oder an dem entlang - der bewegliche Probenträger gleiten oder rollen kann.

10. Vorrichtung nach irgendeinem der Patentansprüche 1 bis 9, in der der bewegliche Probenträger mit Kufen und/oder Rollen (31) versehen ist, die seine Bewegung auf dem Führungsorgan - oder an diesem entlang - erleichtern.

11. Vorrichtung nach irgendeinem der Patentansprüche 1 bis 10, in der eine Wand (65) der Schleuse transparent ist.

12. Vorrichtung nach irgendeinem der Patentansprüche 1 bis 11, in der der bewegliche Probenträger eine sichtbare Markierung (38) trägt.

13. Vorrichtung nach irgendeinem der Patentansprüche 1 bis 12, die einen Hohlkörper (69) aufweist, der die Schleuse mit der Sekundärkammer verbindet und in dessen Innerem sich der bewegliche Probenträger bewegen kann, um zu ermöglichen, diesen beweglichen Probenträger von der Sekundärkammer in die Schleuse und zurück zu bringen.

14. Vorrichtung nach Patentanspruch 13, in der der Hohlkörper (69) eine staubdichte Hülle umfasst, die eine geringe mechanische Steifheit aufweist, um die Übertragung der Vibrationen der Sekundärkammer auf die Schleuse zu begrenzen, wobei dieser Hohlkörper im Wesentlichen aus einer schlauchförmigen Hülle aus einem Kunststoff bestehen kann, insbesondere einer balgförmigen Hülle.

15. Vorrichtung nach irgendeinem der Patentansprüche 1 bis 14, in der die Hauptkammer von Abschirmwänden (12, 13) umgrenzt wird.

16. Vorrichtung nach irgendeinem der Patentansprüche 1 bis 15, in der die Sekundärkammer ein Handschuhkasten ist, der gegenüber der Hauptkammer auf Unterdruck gehalten wird.

## Claims

1. A device (10) for analyzing a material with the help of a microprobe (14), the device comprising:
• a main enclosure (11) containing a secondary enclosure (15);
• a microprobe (14) placed in the main enclosure and fitted with a motion object (20, 22);
• an airlock (26) placed in the main enclosure and connected to the microprobe and to the secondary enclosure; and
• a movable sample support (28) movable from the secondary enclosure to the airlock and from the airlock to the motion object;
and wherein each of the airlock and the motion object includes a respective member (57, 59) for guiding the movable sample support to guide the support while it is being moved, and also a respective sensor (60) for detecting the presence of the movable sample support.

2. A device according to claim 1, wherein the motion object includes an abutment (61) serving to hold the movable sample support in an analysis position.

3. A device according to claim 1 or claim 2, including a slidable control bar (42) for moving the movable sample support from the airlock to the motion object and back again.

4. A device according to claim 3, wherein the movable sample support and the sliding control bar have respective complementary coupling members (39 to 41) designed for engaging mutually so as to provide a mechanical connection between the control bar and the movable sample support.

5. A device according to claim 4, including locking means that enable the coupling members to be mutually separated in a position of the movable sample support on the motion object, referred to as the analysis position, and also in a position of the movable sample support inside the airlock, referred to as the transfer position, while preventing such separation in all other positions of the movable sample support that are intermediate between the analysis position and the transfer position.

6. A device according to any one of claims 1 to 5, including alignment means for aligning the guide member (57) of the airlock and the guide member (59) of the motion object in the event of a power supply failure to the drive motors (23) of the motion object.

7. A device according to claim 6, wherein, for each movement axis of the motion object, the alignment means comprise a drive member (50) engaged with a wormscrew (24) for driving the motion object along that axis, the drive member being actuatable by means of a manipulator member (46) passing through the wall (13) of the main enclosure.

8. A device according to claim 6 or claim 7, wherein, for each axis of the motion object, the alignment means comprise a position sensor sensitive to the position of the motion object along that axis, and a display device connected to the sensor to display the position of the motion object along that axis in a manner that is visible from outside the main enclosure.

9. A device according to any one of claims 1 to 8, wherein at least one of the guide members comprises a rail segment (35, 36, 57 to 59) on or against which the movable sample support can slip, slide, or roll.

10. A device according to any one of claims 1 to 9, wherein the movable sample support is fitted with skids and/or wheels (31) to facilitate its movement on or along the guide member.

11. A device according to any one of claims 1 to 10, wherein a wall (65) of the airlock is transparent.

12. A device according to any one of claims 1 to 11, wherein the movable sample support includes a visible mark (38).

13. A device according to any one of claims 1 to 12, including a hollow structure (69) connecting the airlock to the secondary enclosure, within which the movable sample support can move so as to enable the movable sample support to be transferred from the secondary enclosure to the airlock, and back again.

14. A device according to claim 13, wherein the hollow structure (69) comprises a dustproof covering presenting low mechanical stiffness so as to limit any transmission of vibration from the secondary enclosure to the airlock, the hollow structure possibly being essentially constituted by a corrugated tubular covering made of a plastics material, in particular a covering in the form of a bellows.

15. A device according to any one of claims 1 to 14, wherein the main enclosure is defined by shielded walls (12, 13).

16. A device according to any one of claims 1 to 15, wherein the secondary enclosure is a glove box maintained at a pressure that is lower than the pressure inside the main enclosure.
